Europäisches Patentamt

European Patent Office

Office européen des brevets

⑩

(11) Publication number: **0 070 435**
**B1**

(12) **EUROPEAN PATENT SPECIFICATION**

(45) Date of publication of patent specification: **07.01.88**

(21) Application number: **82105893.0**

(22) Date of filing: **01.07.82**

(51) Int. Cl.⁴: **H 01 L 23/48,** H 01 L 21/60

(54) **Semiconductor device comprising a semiconductor substrate bonded to a mounting means.**

(30) Priority: **02.07.81 JP 104159/81**

(43) Date of publication of application:
**26.01.83 Bulletin 83/04**

(45) Publication of the grant of the patent:
**07.01.88 Bulletin 88/01**

(84) Designated Contracting States:
**DE FR GB**

(56) References cited:
**FR-A-2 081 794**
**GB-A-1 149 606**
**GB-A-1 360 213**

(73) Proprietor: **Matsushita Electronics Corporation**
**1006, Oaza-Kadoma Kadoma-shi**
**Osaka 571 (JP)**

(72) Inventor: **Hattori, Hirotsugu**
**32-14, Matsugaoka 3-chome**
**Takatsuki City 569 (JP)**
Inventor: **Kuwagata, Masahiro**
**14-25, Senrioka-shimo**
**Suita City, 565 (JP)**

(74) Representative: **Dr. Elisabeth Jung Dr. Jürgen**
**Schirdewahn Dipl.-Ing. Claus Gernhardt**
**P.O. Box 40 14 68 Clemensstrasse 30**
**D-8000 München 40 (DE)**

Courier Press, Leamington Spa, England.

## Description

### Background of the invention

#### 1. Field of the technology of the invention

The present invention relates to an improvement in a semiconductor device wherein a multi-layered electrode and a soldering layer bond the semiconductor substrate onto a mounting means, thereby attaining stronger bonding force and higher stability for long time of service.

#### 2. Description of the prior art

Metal electrode layers which are provided on a surface of a semiconductor substrate, and the surface of which is to be bonded with a solder layer onto a mount should fulfil the following conditions:

(1) the metal electrode layer contacting the solder layer must have good wetting properties as regards the latter,

(2) the component of the metal electrode layer contacting the solder layer shall not melt into the solder layer during the soldering process, and the metal electrode layer shall not peel off from the semiconductor substrate,

(3) the metal electrode layer contacting the solder layer shall have a strong bonding force as regards the latter,

(4) the metal electrode layer must be stable and shall have a high reliability when undergoing a long-time hard testing such as thermal fatigue testing, and

(5) no undesirable compound between the solder layer and the metal electrode layer shall be formed in the soldering process.

On the other hand, the solder material should have the following characteristic properties:

(1) it must allow easy bonding,

(2) it must have a good wetting power in respect of the semiconductor substrate, making no voids,

(3) it must have a good electric conductivity,

(4) it must have a good thermal conductivity,

(5) it shall be resistant to oxidation by atmospheric gas, and

(6) it shall have good durability against thermal fatigue.

That is, the solder for the semiconductor substrate bonding, must not only have good physical and chemical characteristics, but also provide the semiconductor device with good electrical and thermal characteristics. In other words it is to be noted that, in bonding a semiconductor substrate on a mounting means together with substances of the electrode layers the solder substance as such gives a great effect to the bonding. Accordingly, in the soldering, consideration on materials should be made, not only on the electrodes of the semiconductor substrate, but also from an overall point of view as a combination with the solder substrate. Especially for semiconductor devices that have to handle large electric powers like power transistors or like ones, it is important to select the materials by considering the brittleness after time lapse, in order to realize a satisfactory resistivity to thermal fatigue.

Hitherto, nickel-plated layers formed by electrolytic process or non-electrolytic process, or nickel layers formed by vacuum deposition process have been used as electrode layers to be bonded by solder. Nickel is superior for this purpose since it does not melt into the solder layer, but has a problem in that it requires a heat treatment at a relatively high temperature in order to attain a strong bonding force to the semiconductor substrate. When a nickel layer is formed by a plating process, it is necessary to carry out a troublesome pretreatment in order to get an excellent adhesion to the substrate surface, and moreover the plated surface is likely to be contaminated by impurities in a plating bath. In order to obtain a good contact, a predetermined impurity is necessary in a contact region of the substrate to form the nickel layer thereon. And therefore, there arises a problem in that a diffusing process is necessary to form the contact region with the impurity.

In order to utilize the good characteristics of nickel for soldering, composite layers of chromium-nickel alloy and nickel or composite layers of chromium, chromium-nickel alloy and nickel have been developed and they are known as multiple layer electrodes. However, even the use of such a multiple layer electrode is not sufficient for attaining a stable and uniform bonding between the semiconductor substrate and the mount. In other words, even though such multiple layer electrodes are suitable for actual use, there is a problem of oxidation of the nickel surface of the multiple layer electrodes in a mass-production line, where there is some waiting time between the electrode formation and subsequent solder bonding for devices in some lots. Therefore, ordinarily, some suitable surface treatment has been made in order to avoid the undesirable influence of oxidation of the surface nickel layers during the waiting time and in order to obtain uniform products. This means an increase in the number of process steps, i.e. the surface treatment, which necessitates another control in respect of treatment conditions; and even with such a treatment, voids are often observed at soldering. In view of the above-mentioned discussion, it is desirable to omit such a surface treatment which has to be effected immediately before the soldering. And it is further considered that to form the nickel layer as the surface layer (uppermost layer) as such induces many problems.

In the prior art (GB—A—1 360 213) there is described a method of mounting a semiconductor chip on a heat sink, the latter being used to dissipate the heat that is created when operating a high power semiconductor device.

For that purpose the semiconductor chip is provided on two opposite surfaces with an aluminum surface, one of which serves later on as thermal and electrical connection with the heat sink.

This latter aluminum surface can have a thickness of 800 nm (8000 Å). A second layer is formed on it, consisting of chromium, titanium or molybdenum. Then a third layer of nickel having a thickness of 600 nm (6000 Å) is formed on the second layer, followed by a fourth layer of a metal being resistant to oxidation, like gold. The fourth layer is joined by a solder layer to the heat sink.

However, aluminum is a soft metal and has a tendency to embrittlement, especially at higher temperatures. Therefore the adherence between the aluminum surface and the surface of the semiconductor chip (silicon wafer) weakens rather easily.

Summary of the invention

The present invention purports to provide a semiconductor device having a satisfactory bonding between a semiconductor substrate and a metal mount.

The present invention can provide a semiconductor device with a good uniformity of bonding between the semiconductor substrate and the mounting means in a mass-production line.

A semiconductor device in accordance with the present invention comprises

a semiconductor substrate,

a multilayered electrode formed on a surface of the semiconductor substrate, the multilayered electrode comprising a chromium-nickel alloy layer, a nickel layer formed thereon

a solder layer and

a mounting means for holding the semiconductor substrate thereon, and is characterized by a noble metal layer of silver, formed further on said nickel layer and having a thickness of over 100 nm (1000 Å),

the solder layer soldering the multilayered electrode onto the mounting means, thereby bonding the semiconductor substrate onto the mounting means.

The multilayered metal electrode structure used in the semiconductor device in accordance with the present invention has the following features: there are substantially no voids at the solder layer as a result of good wetting power of the noble metal in respect of the solder layer, the effective bonding area increases as a result of the decrease of voids, resulting in decrease of thermal resistance by 10 to 20%, the secondary breakdown voltage increases by about 10% thereby increasing reliability, the bonding force is drastically increased, the control of manufacturing in the soldering step becomes easier, the formation of Sn—Ni compounds is suppressed thereby improving resistivity to thermal fatigue, and the oxidation of the surface of the multilayered electrode is eliminated so that no preliminary treatment before the soldering is necessary any more.

Brief explanation of the drawing

The drawing is a sectional elevation view of an example of a semiconductor device embodying the present invention.

Description of the preferred embodiment

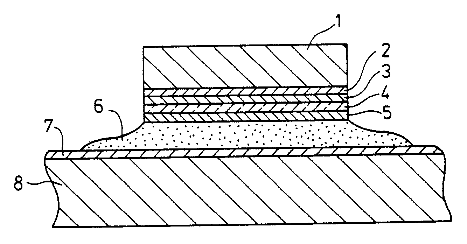

The present invention is hereinafter elucidated in reference to a preferred embodiment configuration of which is shown in Fig. 1, wherein a semiconductor substrate 1 comprises on its one surface (bottom surface in this example), a chromium layer 2, a chromium-nickel alloy layer 3, a nickel layer 4 and a silver layer 5, in this order. The silver layer 5 is then bonded on a solder layer 6 which is formed on a metal plated layer 7 on a surface of a mounting means 8.

The above-mentioned device construction is made in the following process.

First, on the surface of the substrate 1 at the side to be bonded on the mounting means 8, a multi-layered metal electrode of 50 nm (500 Å) thick chromium layer 2, 50 nm (500 Å) thick chromium-nickel alloy layer 3 and 300 nm (3000 Å) thick nickel layer 4 are formed in this order by a consecutive vapor deposition for example using a multiple source electron-beam vapor deposition apparatus, without interrupting the vacuum. The lowermost Cr layer 2 serves to highly strengthen the bonding force between the metal electrode and the semiconductor substrate 1, for instance, a silicon substrate, the second Cr—Ni-alloy layer 3 serves to bond the underlying Cr layer 2 and the overlaying Ni layer 4, and the overlying Ni serves as a metal which wets well with the solder and hardly melts into the solder. As the lowermost layer, the chromium is very excellent to strengthen the bonding force for the silicon substrate. A modified embodiment, wherein the undermost Cr layer is omitted, the Cr—Ni-alloy is formed as the undermost layer and the Ni layer is formed as the second layer, is also of value in practice, although the bonding force is a little lower than that of the above-mentioned three-layer construction. However, since multiple source electron beam vapor deposition apparatus is easily available now. It is of course preferable to provide the undermost Cr layer.

On the three layer metal electrode, which has the Cr layer 2, the Cr—Ni-alloy layer 3 and the Ni layer 4, a silver layer 5 is formed, and the substrate with the four-layer metal electrode is bonded by the solder layer 6 onto the mounting means 8. For the mounting means 8, copper (Cu) or ferro-nickel-alloy (Fe-Ni-alloy) is suitable, and ordinarily a suitable plated layer, for example Ni-plated layer, is formed in order to afford a good wetting with the solder 6.

Preferably the silver layer 5 has a thickness above 300 nm (3000 Å).

Such a silver layer also prevents the formation of undesirable hard and brittle Sn-Ni compounds formed through a reaction of tin (Sn) in the solder and Ni in the metal electrode. The brittle Sn-Ni compounds hitherto have given an undesirable effect to the thermal fatigue characteristic, and accordingly, the prevention of forming such Sn-Ni compounds greatly improves thermal fatigue characteristic of power transistors or the like devices.

Furthermore, the inventors made a research in respect of the contents of solder of two kinds, one containing Pb as host material and the other containing Sn as most material. Through experiments, the inventors confirmed that:

(i) For solders having Pb as host material, when a Pb/Sn two-components composition solder contains 2—10 wt% of Sn and the rest part is Pb, the above-mentioned advantageous characteristics are observed, and

(ii) For solders having Sn as host material, when a Sn/Ag/Sb three-components composition solder contains 2—10 wt% of Ag, 0.1—20 wt% of Sb and the rest part is Sn, the above-mentioned advantageous characteristics are observed.

For solder containing Pb as host material, when the Sn content is lower than 2 wt%, the fluidity of molten solder is not satisfactory and impractical for usage. On the other hand, when the Sn content is higher than 10 wt.-%, the undesirable Sn-Ni compound is likely to be formed, and for over 10 wt% of Sn, the thermal fatigue becomes noticeable. In the solder containing Sn as host material, when Ag is added its fluidity improves, thereby decreasing voids. However, when the content of Ag increases over 10 wt%, the solder becomes brittle; and when the content is under 2 wt%, the effect of Ag is not observed. Therefore the content of Ag should be between 2 to 10 wt%. Also, in the Sn-hosting solder, an addition of Sb improves the oxidation-prevention effect. The content of Sb should be under 20 wt% in order not to make the solder impractically brittle, but under 0.1 wt% no effect is obtainable.

The solder containing Pb as host material is more suitable for semiconductor devices which are raised to relatively high temperatures, while the solder containing Sb as host material is more suitable for semiconductor devices which are used at relatively low temperature. Experiments proved however, that there is no significant difference between the electric characteristics of the semiconductor devices using the Pb-hosting solder and the Sb-hosting solder.

The multilayered metal electrode structure used in the semiconductor substrate in accordance with the present invention has shown the following beneficial features:

(1) There are substantially no voids at the solder layer as a result of good wetting of the silver in respect of the solder layer.

(2) The effective bonding area increases as a result of the decrease of voids, resulting in a decrease of thermal resistance by 10 to 20%.

(3) The secondary breakdown voltage increases by about 10% thereby increasing reliability.

(4) The bonding force is drastically increased.

(5) The control of manufacturing in the soldering step becomes easier.

(6) The formation of undesirable brittle Sn-Ni compounds is suppressed, thereby improving resistivity to thermal fatigue.

(7) The oxidation of the surface of the multilayered electrode is eliminated, thereby making the preliminary treatment before the soldering step unnecessary.

Therefore, as a result of the above features, the present invention is advantageous in improving easiness of the fabricating process and also in improving electrical, mechanical and life-time characteristics of the devices.

**Claims**

1. A semiconductor device comprising:
a semiconductor substrate (1),
a multilayered electrode (3, 4) formed on a surface of said semiconductor substrate (1) and comprising a chromium-nickel alloy layer (3), a nickel layer (4) formed thereon,
a solder layer (6) and
a mounting means (8) for holding said semiconductor substrate thereon,
characterized by
a noble metal layer (5) of silver formed further on said nickel layer (4) and having a thickness of over 100 nm (1000 Å),
said solder layer soldering said multilayered electrode onto said mounting means, thereby bonding said semiconductor substrate onto said mounting means.

2. A semiconductor device in accordance with claim 1, which further comprises a chromium layer (2) formed between said semiconductor substrate (1) and said chromium-nickel alloy layer (3).

3. A semiconductor device in accordance with claim 1 or 2, wherein said solder (6) contains 2—10 wt% of Sn and the rest is lead.

4. A semiconductor device in accordance with claim 1 or 2, wherein said solder (6) contains 2—10 wt% silver, 0.1—20 wt% antimony and the rest is tin.

5. A semiconductor device in accordance with any of claims 1 to 4, wherein said noble metal layer of silver (5) has a thickness of over 300 nm (3000 Å).

**Patentansprüche**

1. Eine Halbleiteranordnung, umfassend:
ein Halbleitersubstrat (1),
eine mehrschichtige Elektrode (3, 4), die auf einer Oberfläche des besagten Halbleitersubstrats (1) gebildet ist und eine Cr-Ni-Legierungsschicht (3) und eine darauf gebildete Nickelschicht (4) aufweist,
eine Lötmetallschicht (6) und
einen Träger (8) zum Festhalten des besagten Halbleitersubstrats, dadurch gekennzeichnet, daß eine Edelmetallschicht (5) aus Silber zusätzlich auf besagter Nickelschicht (4) gebildet ist und eine Dicke von über 100 nm (1000 Å) aufweist, wobei besagte Lötmetallschicht besagte mehrschichtige Elektrode auf besagtem Träger auflötet und dadurch das besagte Halbleitersubstrat an den besagten Träger bindet.

2. Eine Halbleiteranordnung gemäß Anspruch 1, welche zusätzliche eine Chromschicht (2) aufweist, welche zwischen besagtem Halbleitersubstrat (1) und besagter Cr-Ni-Legierungsschicht (3) gebildet ist.

3. Eine Halbleiteranordnung gemäß Anspruch 1 oder 2, in welcher besagte Lötmetallschicht (6) 2 bis 10 Gewichtsprozent Zinn aufweist und der Rest aus Blei besteht.

4. Eine Halbleiteranordnung gemäß Anspruch 1 oder 2, in welcher besagte Lötmetallschicht (6) 2 bis 10 Gewichtsprozent Silber und 0,1 bis 20 Gewichtsprozent Antimon enthält und der Rest aus Zinn besteht.

5. Eine Halbleiteranordnung gemäß irgendeinem der Ansprüche 1 bis 4, in welcher besagte Edelmetallschicht (5) aus Silber eine Dicke über 300 nm (3000 Å) aufweist.

## Revendications

1. Dispositif à semi-conducteur comprenant:

— un substrat à semi-conducteur (1),
— une électrode à couches multiples (3, 4) formée sur une surface du substrat à semi-conducteur (1) et comprenant une couche (3) d'alliage chrome-nickel, une couche de nickel (4) formée sur son dessus,
— une couche de soudure (6) et
— un moyen de montage (8) afin de maintenir le substrat à semi-conducteur sur son dessus, caractérisé par:

— une couche de métal noble (5) en argent formée en outre sur la couche de nickel (4) et ayant une épaisseur supérieure à 100 nm,
— la couche de soudure soudant l'électrode à couches multiples sur le moyen de montage, d'où la liaison du substrat à semi-conducteur au moyen de montage.

2. Dispositif à semi-conducteur selon la revendication 1, qui comprend en outre une couche de chrome (2) formée entre le substrat à semi-conducteur (1) et la couche (3) d'alliage chrome-nickel.

3. Dispositif à semi-conducteur selon la revendication 1 ou la revendication 2, dans lequel la soudure (6) contient de 2 à 10% en poids de Sn, le reste étant du plomb.

4. Dispositif à semi-conducteur selon la revendication 1 ou la revendication 2, dans lequel la soudure (6) contient de 2 à 10% en poids d'argent, de 0,1 à 20% en poids d'antimoine, le reste étant de l'étain.

5. Dispositif à semi-conducteur selon l'une quelconque des revendications 1 à 4, dans lequel la couche de métal noble en argent (5) a une épaisseur supérieure à 300 nm.